Europäisches Patentamt

European Patent Office

Office européen des brevets

(11) Veröffentlichungsnummer: **0 387 507 B1**

## (12) EUROPÄISCHE PATENTSCHRIFT

(45) Veröffentlichungstag der Patentschrift: **06.04.94**

(21) Anmeldenummer: **90101608.9**

(22) Anmeldetag: **26.01.90**

(51) Int. Cl.⁵: **H03H 17/06**

(54) Einrichtung zur Umwandlung der Abtastraten von Digitalsignalen.

(30) Priorität: **02.02.89 AT 211/89**

(43) Veröffentlichungstag der Anmeldung:
**19.09.90 Patentblatt 90/38**

(45) Bekanntmachung des Hinweises auf die
Patenterteilung:
**06.04.94 Patentblatt 94/14**

(84) Benannte Vertragsstaaten:
**AT BE CH DE DK ES FR GB GR IT LI LU NL SE**

(56) Entgegenhaltungen:
**EP-A- 0 052 847**
**EP-A- 0 099 600**

**E. KREYSZIG: "Advanced Engineering Mathematics", Auflage 4, 1979, Seiten 774-777, John Wiley & Sons, New York, US**

(73) Patentinhaber: **Siemens Aktiengesellschaft Österreich**
**Siemensstrasse 88 - 92**
**A-1210 Wien(AT)**

(72) Erfinder: **Kraker, Alfred**
**Kollergasse 17**
**A-1030 Wien(AT)**

(74) Vertreter: **Atzwanger, Richard, Dipl.-Ing. Patentanwalt**
**Mariahilfer Strasse 1c**
**A-1060 Wien (AT)**

**Beschreibung**

Die Erfindung betrifft eine Einrichtung zur Umsetzung eines mit einer vorgegebenen Eingangs-Abtastrate (f = l/T) empfangenen digitalen Signales $y_n$ = y(n.T);(n = 0,1,2..), das ein ursprünglich analoges Signal durch dessen Abtastwerte zu den Abtastzeitpunkten (n.T) repräsentiert, in andere Ausgangs-Abtastwerte $y_k$ = y(k.T'); (k = 0,1,2...), die eine von der Eingangs-Abtastrate (f) (im allgemeinen) verschiedene Ausgangs-Abtastrate (f' = l/T') aufweisen, wobei auch diese Ausgangs-Abtastwerte eine gültige Signalrepräsentation des ursprünglichen analogen Signals darstellen, unter Verwendung eines Interpolationsrechners, der einerseits aus von aufeinanderfolgenden Eingangs-Abtastwerten abgeleiteten Stützwerten und anderseits aus mittels eines Zeitzählers gemessenen Zeitdifferenzen zwischen Ein- und Ausgangs-Abtastzeitpunkten die Ausgangs-Abtastwerte errechnet.

Nach dem Abtasttheorem kann ein kontinuierliches Signal aus einem durch aequidistante Abtastung entstandenen Abtastsignal mit Hilfe eines idealen Tiefpasses rekonstruiert werden, wenn das konstruierte Signal mit einer oberen Frequenzgrenze bandbegrenzt und die Abtastfrequenz größer als die doppelte Frequenzobergrenze ist. Da also bei vorgegebener Nutzbandbreite nur eine Mindestgröße der Abtastfrequenz gefordert ist, haben sich verschiedene Standards z.B. für Audioanwendungen mit den Abtastfrequenzen 32 kHz, 44.1kHz, 48 kHz usw. herausgebildet. Liegt aber ein Audiosignal in digitaler Repräsentation für eine bestimmte Abtastfrequenz vor, so entstehen erhebliche Probleme, falls diese mit Audiosignalen anderer Abtastfrequenzen verknüpft (gemischt) werden sollen oder wenn ein Audiosignal mit einer gegebenen Abtastfrequenz in einer mit einer anderen Abtastfrequenz umgewandelt werden soll.

Eine triviale, jedoch qualitativ unbefriedigende und teure Lösung besteht darin, das mit der einen Abtastfrequenz angebotene digitale Signal in ein Analogsignal umzusetzen und das letztere danach neuerlich mit der gewünschten Ausgangsabtastfrequenz zu digitalisieren.

Aus EP-A-0 099 600 und EP-A-0 052 847 sind auch Anordnungen zur Umsetzung der Abtastfrequenz Ohne Verlassen des digitalen Bereichs bekannt

Durch die EP-A2 84 945 ist ein Abtastratenwandler für digitale Ein- und Ausgangssignale bekannt geworden, der auf der Basis einer linearen Interpolation zwischen aufeinanderfolgenden Abtastwerten arbeitet, um Ausgangs-Abtastwerte mit einer von der Eingangs-Abtastrate verschiedenen Ausgangs-Abtastrate zu gewinnen. Hierbei werden mittels eines Digitalfilters Zwischen-Abtastwerte mit einer Hilfs-Abtastfrequenz erzeugt, die ein ganzzahliges Vielfaches, z.B. das 400-fache der Eingangs-Abtastfrequenz beträgt. Diese Hilfs-Abtastfrequenz ist deshalb so hoch gewählt, daß Änderungen im Signalverlauf zwischen zwei Zeitpunkten zweier Zwischen-Abtastwerte jeweils so gering sind, daß zur Ermittlung von Zwischenwerten innerhalb der durch ganzzahlige Interpolation gefundenen Werte eine lineare Interpolation genügt. Daher wird der Ausgangs-Abtastwert bei dem in der o.a. EP-A2 beschriebenen Abtastratenwandler unter Verwendung der benachbarten Zwischen- Abtastwerte als Stützwerte durch lineare Interpolation errechnet. Eine Methode bzw. eine Schaltung zur Durchführung einer nichtlinearen Interpolation ist in dieser Schrift nicht angegeben.

Im Gegensatz zu dieser bekannten Methode löst die Erfindung die Aufgabe der Abtastratenwandlung auch bei völliger Unabhängigkeit und Inkommensurabilität der Ein- und Ausgangsabtastraten ohne Zuhilfenahme einer aufwendigen Zwischen-Abtastratenvervielfachung. Erfindungsgemäß wird dies durch die Merkmale des Anspruchs 1 erzielt.

Weitere Kennzeichen der Erfindung sind in den Unteransprüchen 2 und 3 enthalten.

Das Diagramm der Fig. 1 dient der Erläuterung der Interpolationsmethode nach Everett-Laplace. Die erfindungsgemäße Anwendung dieser Methode auf ein zeitabhängiges Signal y(t) veranschaulicht die Fig. 2. Ein Ausführungsbeispiel der erfindungsgemäßen Einrichtung ist, aufgeteilt in einzelnen Schaltungsdetails, in den Fig. 3, 4 und 5 dargestellt.

Eine nichtlineare Interpolation geht aus von einem Polynom N-ter Ordnung, das im vorgesehenen Interpolationsintervall die zu reproduzierende Funktion optimal annähert. Zur Gewinnung eines Polynoms N-ter Ordnung werden allgemein N + 1 Funktionswerte (Stützwerte) der zu reproduzierenden Funktion benötigt. Es gibt verschiedene Interpolationsverfahren, die sich durch unterschiedlichen Rechenaufwand unterscheiden. Jede Interpolation bedarf zweier getrennter vorbereitender Rechenvorgänge, nämlich einerseits der Ermittlung der charakteristischen Werte für jenes Polynom, mit dem die Interpolation durchgeführt wird und anderseits der Bestimmung weiterer charakteristischer Werte, die sich aus der Position des zu ermittelnden Abtastwertes innerhalb des Interpolationsintervalles ergeben.

Für Interpolationen gibt es eine Reihe von Interpolationsverfahren mit unterschiedlichem Rechenaufwand, der sich dann reduziert, wenn die das Polynom bestimmenden Stützwerte aequidistant sind. Aber auch unter diesen, unter der genannten vereinfachenden Bedingung stehenden Interpolationsverfahren bestehen Unterschiede im Rechenaufwand. Aus operationstechnischen Gründen bedient sich die Erfindung eines speziellen Interpolationsverfahren, nämlich jenes, das nach der Methode nach Everett-Laplace durchgeführt wird. Diese Methode zeichnet sich dadurch aus, daß sie mittels einer einfachen Schaltung durchführbar ist, die vor allem den gleichzeitigen Ablauf mehrerer miteinander korrespondierender Rechenvorgänge erlaubt, wodurch eine hohe Rechengeschwindigkeit ermöglicht wird, welche es ihrerseits erst erlaubt, in Echtzeit mit ausreichender Qualität eine Signalrekonstruktion bei geänderter Abtastfrequenz zu gewährleisten.

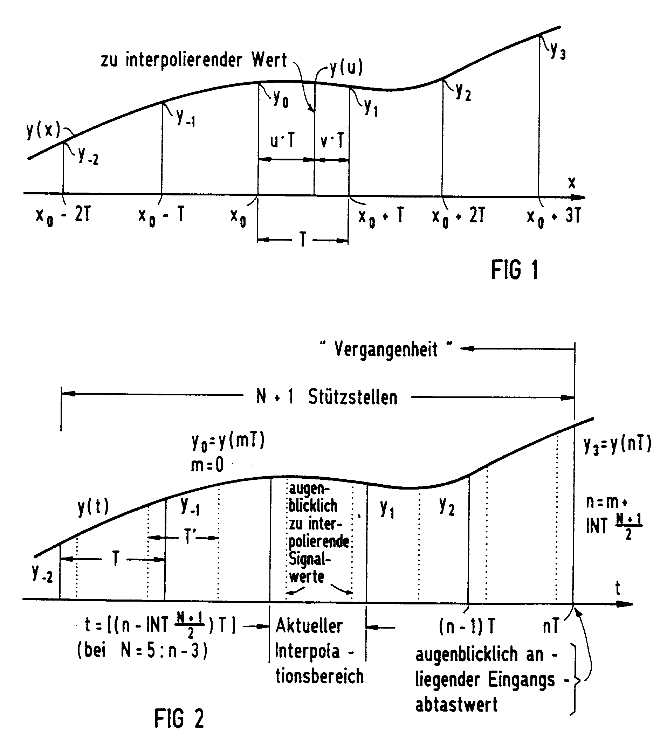

In Fig. 1 ist ein Abschnitt einer - zunächst als statisch aufzufassenden - Kurve $y(x)$ dargestellt, die durch das genannte Interpolationsverfahren durch ein Polynom N-ter Ordnung, im vorliegenden Fall durch ein Polynom fünfter Ordnung angenähert werden soll. Demgemäß sind zur Bestimmung dieses Polynoms sechs Werte erforderlich, die in Fig. 1 durch die sechs aequidistanten Stützwerte $y_{-2} = y(x_o$-2T$),... y_o = y(x_o),...y_3 = y(x_o+3T)$ gegeben sind. Diese sechs Stützwerte werden zur Interpolation der Funktion $y(x)$ innerhalb des Interpolationsintervalles von der Breite T zwischen den Argumentwerten $x_o$ und $x_o+T$, denen die Funktionswerte $y_o$ und $y_1$ entsprechen, herangezogen. Hierbei muß aber außer der Festlegung des aus den Stützwerten zu ermittelnden Polynoms z-zusätzlich noch das Argument auf der x-Achse gegeben sein, für das der zugehörige Funktionswert $y(x)$ errechnet werden soll.

Da bei der erfindungsgemäßen Einrichtung im Zuge der Durchführung einer Interpolation das jeweilige Interpolationsintervall, dessen Grenz-Stützwerte hier immer mit $y_o$ und $y_1$ bezeichnet sind, von vorneherein festgelegt ist, bedarf es zur Festlegung des Argumentes innerhalb dieses Intervalles von der Breite T nur der Angabe der Anteile u.T (0 kleiner gleich u und u kleiner als 1) bzw. v.T (v = 1-u) dieser Breite T, um die dieses Argument von den Intervallgrenzen (u = 0 und u = 1) entfernt ist. Reduziert auf das Intervall zwischen $y_o$ und $y_1$ kann also die Funktion $y(x)$ durch die Funktion $y(u)$ ersetzt werden. Solcherart vereinfacht ergibt sich für die Interpolation nach Everett-Laplace die folgende Formel:

$$y(u) = vy_0 + \binom{v+1}{3} "D^2"(y_0) + \binom{v+2}{5} "D^4"(y_0) + \ldots$$

$$+ uy_1 + \binom{u+1}{3} "D^2"(y_1) + \binom{u+2}{5} "D^4"(y_1) + \ldots,$$

wobei die Ausdrücke

$"D^2"(y_o) = y_{-1} - 2y_o + y_1$

und

$"D^4"(y_o) = "D^2"(y_{-1}) - 2"D^2"(y_o) + "D^2"(y_{+1})$

spezielle Differenzstrukturen zweiter und vierter Ordnung bedeuten. Die Ordnung dieser Differenzstrukturen läßt sich beliebig erhöhen, so ergibt sich beispielsweise für jene der sechsten Ordnung der Ausdruck

$"D^6"(y_o) = "D^4"(y_{-1}) - 2"D^4"(y_o) + "D^4"(y_{+1})$.

Die Differenzstruktur $"D^2"(y_o)$ zweiter Ordnung, die ein Maß für die Krümmung des Kurvenstückes beim Stützwert $y_o$ darstellt, erfaßt auch notwendigerweise die benachbarten Stützwerte $y_{-1}$ und $y_1$, also insgesamt drei Stützwerte. Die Differenzstruktur $"D^4"(y_o)$ vierter Ordnung erfaßt hingegen fünf Stützwerte und die beiden um die Breite T des Interpolationsintervalles gegeneinander verschobenen Differenzstrukturen $"D^4"(y_o)$ und $"D^4"(y_1)$ erfassen insgesamt sechs Stützwerte, also wie in Fig. 1 gezeigt, die Stützwerte $y(x_o$-2T$) = y_{-2}$ bis $y(x_o+3T) = y_3$. Das durch die o.a. Everett- Formel bestimmte Interpolationspolynom ist somit von fünfter Ordnung.

Anhand der Fig. 2 wird im folgenden erläutert, wie durch Anwendung der in Fig. 1 statisch dargestellten Interpolation die durch die erfindunsgemäße Einrichtung zu bewerkstelligende Abtastratenumwandlung vollzogen wird. Hierbei wird die beschriebene Interpolation auf ein zeitabhängiges Analogsignal $y(t)$ angewendet, das in digitale Abtastwerte $y_n = y(n.T)$ umgesetzt, mit der vorgegebenen Abtastrate f = I/T am Eingang der erfindungsgemäßen Einrichtung empfangen wird. Von der erfindungsgemäßen Einrichtung werden die empfangenen Eingangs-Abtastwerte $y_n$ in andere Ausgangs-Abtastwerte $y_k = y(kT')$ umgesetzt, die das gleiche Analogsignal $y(t)$ abbilden, jedoch eine andere Ausgangs-Abtastrate f' = I/T' aufweisen als die Eingangs-Abtastwerte $y_n$, wobei die Abtastraten f und f' in beliebigen Verhältnissen zueinander stehen können.

Die erfindungsgemäße Einrichtung ist ein Interpolationsrechner, der jene Ausgangs-Abtastwerte synthetisiert, deren Abtastzeitpunkte zwischen den Abtastzeitpunkten bestimmter, früherer Eingangs-Abtastwerte liegen. Das Neue der Erfindung gegenüber dem bekannten Interpolationsrechner, welcher eine lineare Interpolation unter ausschließlicher Verwendung der das jeweilige Interpolationsintervall begrenzenden Eingangs-Abtastwerte als Stützwerte durchführt, besteht darin, daß sie sich der angrenzenden, symmetrisch zum augenblicklich aktuellen Interpolationsintervall liegenden Stützwerte bedient, um zu einer nichtlinearen Interpolation mit der genannten höheren Rekonstruktionsqualität zu gelangen, in dem die errechneten Ausgangs-Abtastwerte $y_k$ viel besser die zugehörigen Werte des ursprünglichen Analogsignales $y(t)$ approximieren als dies mittels einer linearen Interpolation möglich wäre.

In der Darstellung nach Fig. 2 sind die mit stark ausgezogenen Linien angedeuteten Stützwerte im Gegensatz zur Darstellung nach Fig. 1 keine statischen Werte, sondern die Eingangs-Abtastwerte $y_n$ = y-(nT) des zeitabhängigen Analogsignales $y(t)$, die im Rhythmus des Eingangs-Abtasttaktes f = I/T empfangen werden. Mit punktierten Linien sind hingegen die von der erfindungsgemäßen Einrichtung zu errechnenden Ausgangs-Abtastwerte $y_k$ = y(k.T') angedeutet, deren Abtastrate f' = I/T' im Beispiel höher ist als der Eingangs-Abtastrate f. Das Diagramm der Fig. 1 ist als eine Momentaufnahme der Kurve $y(t)$ nach Fig. 2 zu verstehen, wobei sich der Ausschnitt nach Fig. 1 im Lauf der Zeit nach rechts, also in Richtung höherer Zeitwerte verschiebt, wobei im Zeitabstand T die nächste Momentaufnahme gemacht wird.

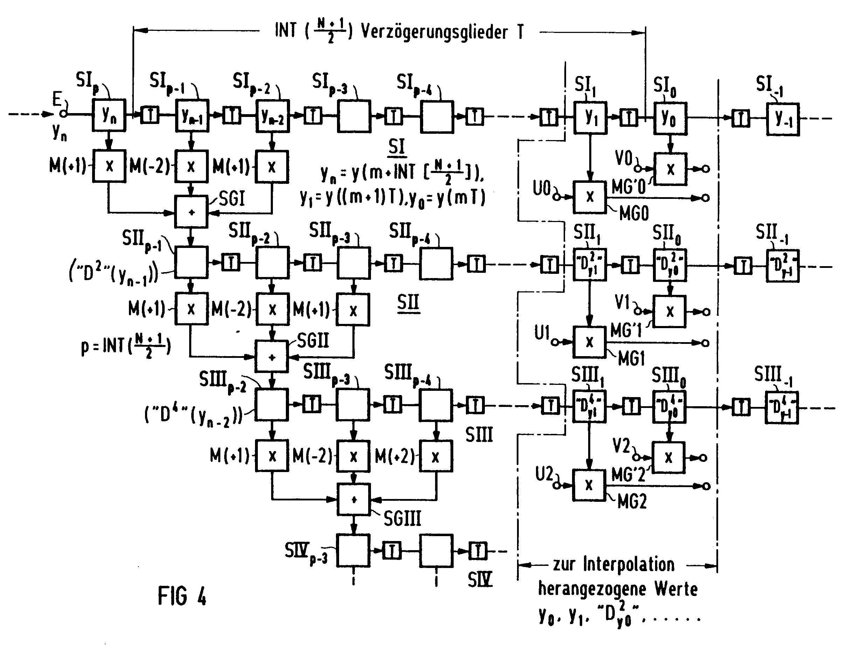

In Fig. 4 ist eine erste Schiebespeicherkette SI dargestellt, in deren Speicher $SI_p$, $SI_{p-1}$... die Abtastwerte $y_n$, $y_{n-1}$...$y_{n-N}$ eingeschrieben sind, wobei zwischen je zwei benachbarten Speichern je ein Verzögerungsglied eingeschaltet ist. Diese Verzögerungsglieder sind einheitlich mit T bezeichnet, um anzudeuten, daß sie zu jedem Abtastzeitpunkt die Information von einem Speicher in den nächsten weiterleiten, daß also in zwei benachbarten Speichern um je ein Abtastintervall T verschobene Abtastwerte vorhanden sind. Die zur Berechnung der Ausgangs-Abtastwerte $y_k$ herangezogenen Eingangs-Abtastwerte $y_o$ und $y_1$ sind jeweils im Speicher SI0 bzw. SI1 der ersten Schiebespeicherkette SI gespeichert, während der jeweils jüngste Eingangs-Abtastwert $y_n$ über den Eingangsanschluß E in den ersten Speicher $SI_p$ eingeschrieben wird. Die Anzahl N der insgesamt in der ersten Schiebespeicherkette SI vorhandenen Speicher hängt von der Ordnung N des zur Anwendung kommenden Interpolationspolynoms ab. Im Sinne einer laufenden Indizierung m der Abtastwerte,die hier nicht weiter angewendet wird, ergibt sich für das jeweils zur Berechnung anstehende Abtastintervall der Index

$$m = n - INT\left(\frac{N+1}{2}\right).$$

Mit SII ist eine zweite Schiebespeicherkette bezeichnet, die von den ersten drei Speichern der ersten Schiebespeicherkette SI über ein erstes Summierglied SGI die Summe der der Reihe nach mit den Faktoren +1, -2 und +1 multiplizierten Speicherinhalte dieser drei Speicher, also den Differenzstrukturwert zweiter Ordnung "$D^2$"$(y_{n-1})$ = $y_n - 2y_{n-1} + y_{n-2}$ erhält. Dieser Wert wird bei jedem Abtastzeitpunkt neu errechnet und mit der Verzögerung T eines Abtastintervalles an den nächsten Speicher $SII_{p-2}$ weitergegeben. In der Speicherkette SII enthalten die Speicher $SII_0$ bzw. $SII_1$ die Werte "$D^2$"$(y_o)$ bzw. "$D^2$"$(y_1)$. Die die Multiplikationen mit den Faktoren +1, -2 und +1 ausführenden Multiplizierglieder sind einheitlich mit M-(+1), M(-2) bzw. M(+1) bezeichnet, wobei die "Multiplikation mit dem Faktor 1" eine Synchronisierung der Datenbereitstellung mit der aus der Multiplikation mit dem Faktor -2 hervorgehenden Datenbeistellung bedeutet. Das mit diesen Daten beaufschlagte Summierglied ist einheitlich mit SG bezeichnet.

In analoger Weise wird aus den in den ersten drei Speichern der Speicherkette SII enthaltenen Differenzstrukturwerten zweiter Ordnung nach Multiplikation mit den Werten +1, -2 und +1 und nachfolgender Summierung der Differenzstrukturwerte vierter Ordnung "$D^4$"$(y_{N-2})$ = "$D^2$"$(y_{N-2})$-2."$D^2$"$(y_{N-1})$-+"$D^2$"$(y_N)$ gebildet. Am Ende der Speicherkette SIII enthalten die Speicher $SIII_0$ bzw. $SIII_1$ die Werte "$D^4$"-$(y_0)$ bzw. "$D^4$"$(y_1)$. In analoger Weise können aus den Differenzstrukturwerten vierter Ordnung in weiteren Schiebespeicherketten weitere Differenzstrukturwerte sechster und noch höherer Ordnung gebildet werden.

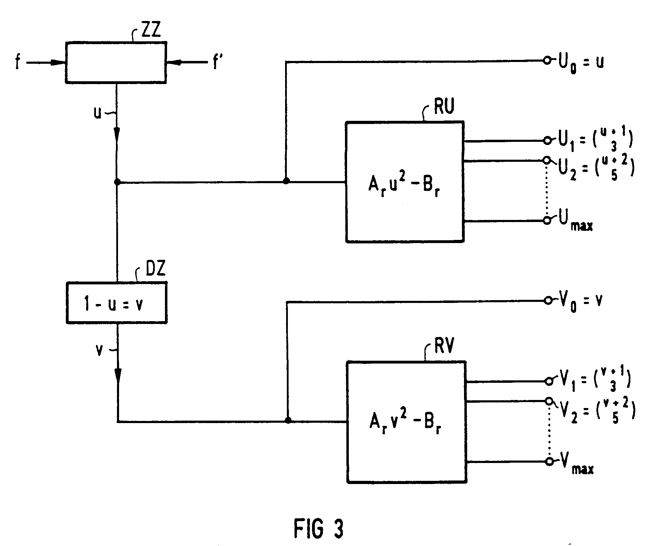

Die in Fig. 3 gezeigte Schaltung dient der Ermittlung jener Werte, die für die Position u bzw. v (den Abtastzeitpunkt) des bzw. der zu errechnenden Ausgangs-Abtastwerte $y_k$ innerhalb des jeweils gegenwärtigen Abtastintervalles charakteristisch sind. Hierzu dient ein Zeitzähler Z, dem einerseits die Eingangs-Abtastzeitpunkte mit der Abtastrate f = I/T und anderseits die Ausgangs-Abtastzeitpunkte mit der Abtastrate f' = I/T' zugeführt werden. Mit jedem Eingangs-Abtastzeitpunkt beginnt der Zeitzähler ZZ seinen Lauf und präsentiert an seinem Ausgang zu jedem Ausgangs-Abtastzeitpunkt sein Zählergebnis u. Mittels eines Differenzzählers DZ wird aus dem Ausgangswert u des Zeitzählers ZZ der Wert v = 1-u gebildet.

4

Für die Anwendung der Everett-Formel sind, wie oben angeführt, einerseits die Werte u und v selbst und anderseits die Binomialkoeffizienten

$$\binom{u+1}{3}, \ \binom{u+2}{5} \ldots \ und \ \binom{v+1}{3}, \ \binom{v+2}{5} \ldots$$

erforderlich. Die Errechnung dieser Binomialkoeffizienten läßt sich aufgrund der Beziehung

$$\binom{u+r}{2r+1} = \binom{u+(r-1)}{(2r-1)} \cdot \frac{(u+r)(u-r)}{2r(2r+1)}$$

mit r = 1,2,... vereinfachen. Der auf der rechten Seite obiger Gleichung an zweiter Stelle stehende Faktor

$$\frac{(u+r)(u-r)}{2r(2r+1)} = A_r u^2 - B_r$$

ist wegen seiner Form sehr einfach zu bilden. Dieser Faktor ändert sich im Intervall zwischen 0 und 1 parabolisch und kann daher auch in diesem Intervall durch seinen Mittelwert

$$\overline{A_r u^2 - B_r} = (1/3) \ A_r - B_r$$

angenähert werden. Hierfür ergibt sich z.B. für r = 1...5 die folgende tabellarische Darstellung:

| r | $A_r = 1/(2r(2r+1))$ | $B_r = r^2/(2r(2r+1))$ | $(1/3)A_r - B_r$ |
|---|---|---|---|
| 1 | 1/6 | 1/6 | -1/9 |
| 2 | 1/20 | 1/5 | -11/60 |
| 3 | 1/42 | 3/14 | -13/63 |
| 4 | 1/72 | 2/9 | -47/216 |
| 5 | 1/110 | 5/22 | -37/165 |

Diese Tabelle genügt bereits zur rekursiven Berechnung der benötigten Binomialkoeffizienten bis zur 11. Ordnung des Interpolationspolynoms. Eine Erweiterung auf höhere Ordnungen ist offensichtlich leicht möglich.

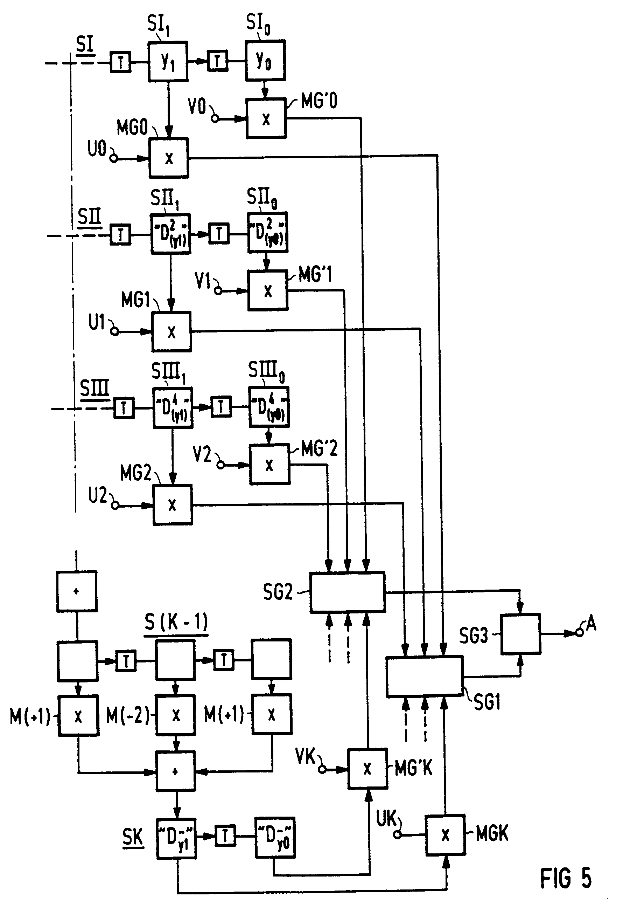

In der Schaltung nach Fig. 3 sind zwei von den Werten u und v beaufschlagte Rechner RU und RV vorgesehen, die gemäß der Rekursionsformel mit o.a. Tabelle die Binomialkoeffizienten errechnen und diese an den zugeordneten Ausgängen ausgeben. Der später im Zusammenhang mit der Fig. 4 benötigten vereinfachten Darstellung wegen sind die einzelnen Werte mit den Bezeichnungen $U_0$, $U_1$... und $V_0$, $V_1$... versehen und in Fig. 5 sind jene Eingänge von zugeordneten Multipliziergliedern MG0, MG'0; MG1, MG'1;... , denen diese Werte zugeführt werden, mit den gleichen Bezeichnungen versehen, wobei die mit Apostrophen bezeichneten Multipliziergliedern MG'0, MG'1... die von den Werten $y_o$, "$D^2$"($y_o$)... abgeleiteten Werte verarbeiten und somit an die entsprechenden Speicher der Schiebespeicherketten angeschlossen sind, während die anderen, ohne Apostrophen bezeichneten Multiplizierglieder MG0, MG1... an die unmittelbar davor liegenden Speicher angeschlossen sind.

Fig. 5 zeigt den Ausgangsteil der erfindungsgemäßen Schaltung. Hierbei ist der übersichtlichen Darstellung wegen der in Fig. 4 rechts der linken vertikalen strichpunktierten Linie gezeichnete Teil der Schaltung nochmals vorhanden, um im Zusammenhang mit den Schaltungselementen, die der Bildung der Differenzstruktur mit der höchsten vorkommenden Ordnung (K) dienen, dargestellt werden zu können. Die entsprechenden Werte werden in der K-ten Schiebespeicherkette SK, die bloß ein Verzögerungselement enthält, transportiert.

Zwei Summierglieder SG1 und SG2 verarbeiten die aus den beiden Gruppen der Multiplizierglieder MG0, MG1... einerseits und der Multiplizierglieder MG'0, MG'1... gewonnenen Werte zu Zwischensummen, die schließlich von einem dritten Summierglied SG3 zum Ausgangssignal A aufsummiert werden.

**Patentansprüche**

1.  Einrichtung zur Umsetzung eines mit einer vorgegebenen Eingangs-Abtastrate ($f = I/T$) empfangenen digitalen Signales $y_n = y(n.T)$; ($n = 0,1,2..$), das ein ursprünglich analoges Signal durch dessen Abtastwerte zu den Abtastzeitpunkten ($n.T$) repräsentiert, in andere Ausgangs-Abtastwerte $y_k = y(k.T')$; ($k = 0,1,2...$), die eine von der Eingangs-Abtastrate ($f$) (im allgemeinen) verschiedene Ausgangs-Abtastrate ($f' = I/T'$) aufweisen, wobei auch diese Ausgangs-Abtastwerte eine gültige Signalrepräsentation des ursprünglichen analogen Signals darstellen, unter Verwendung eines Interpolationsrechners, der einerseits aus von aufeinanderfolgenden Eingangs-Abtastwerten abgeleiteten Stützwerten und anderseits aus mittels eines Zeitzählers gemessenen Zeitdifferenzen zwischen Ein- und Ausgangs-Abtastzeitpunkten die Ausgangs-Abtastwerte errechnet, **dadurch gekennzeichnet**, daß ein Differenzenstrukturrechner zur Gewinnung eines, zeitlich zwischen zwei benachbarten Eingangs-Abtastwerten $y_o = y(mT)$ und $y_1 = y((m+1)T)$ gelegenen Ausgangs-Abtastwertes y, in Form des Funktionswertes eines Polynoms N-ten Grades mit

$$m = n - INT \left(\frac{N+1}{2}\right),$$

gemäß der Formel (Everett-Formel) :

$$y(u) = vy_o + \binom{v+1}{3}"D^2"(y_o) + \binom{v+2}{5}"D^4"(y_o) + \ldots$$

$$+ uy_1 + \binom{u+1}{3}"D^2"(y_1) + \binom{u+2}{5}"D^4"(y_1) + \ldots$$

vorgesehen ist, wobei die im Intervall zwischen den Stützwerten $y_o$ und $y_1$ als Bereich zwischen 0 und 1 linear definierten Lageparameter u und $v = 1-u$ den, zwischen den Grenzen $y_o = y(u=o)$ und $y_1 = y(u=1)$ gelegenen, Interpolationswert $y(u)$ bestimmen und wobei die Ausdrücke

$$"D^2"(y_o) = y_{-1} - 2y_o + y_1$$

und

$$"D^4"(y_o) = "D^2"y_{-1} - 2"D^2"y_o + "D^2"y_{+1}$$

u.s.w.,

spezielle Differenzenstrukturen zweiter und vierter, sechster u.s.w. Ordnung von jeweils drei aufeinanderfolgenden Werten $y_{-1} = y((m-1)T)$; $y_o = y(mT)$; $y_1 = y((m+1)T)$ bedeuten, und daß der Differenzenstrukturrechner aus Schiebespeicherketten verschiedener Ordnungen besteht, wobei die aus Speichern und einer Kaskade von N hintereinander geschalteten Einheitsverzögerungsglieder mit jeweils einer Verzögerungszeit vom Ausmaß einer Abtastperiode T bestehende erste Schiebespeicherkette (SI) von den Eingangs-Abtastwerten y(nT), y((n-1)T), y((n-2)T),... im Takt der Eingangs-Abtastrate (f) durchlaufen wird und daß an die drei ersten Speicher der ersten Schiebespeicherkette (SI) je ein Multiplizierglied (M) zur Multiplikation der Inhalte dieser drei Speicher ($SI_1 ...$) mit den Faktoren +1, -2 bzw. +1 angeschlossen ist und die Ausgänge dieser Multiplizierglieder (M) weiters an ein gemeinsames Summierglied (SGI) angeschlossen sind, dessen Ausgang mit dem ersten Speicher der aus Speichern und einer Kaskade von N-2 Einheitsverzögerungsgliedern (T) bestehenden zweiten Schiebespeicherkette (SII) verbunden ist und die so gewonnenen Differenzenstrukturwerte $"D^2"y$ der Reihe nach im Eingangs-Abtasttakt (T) in die zweite Schiebespeicherkette (SII) einspeist und daß in analoger Weise an die drei ersten Speicher der zweiten Schiebespeicherkette (SII) jeweils ein weiteres Multiplizierglied (M) zur Multiplikation der Inhalte dieser drei Speicher mit den Faktoren +1, -2 bzw. +1 angeschlossen ist und die Ausgänge dieser Multiplizierglieder (M) an ein weiteres Summierglied (SGII) angeschlossen sind, dessen Ausgang mit dem ersten Speicher einer aus einer Kaskade mit N-4 Einheitsverzögerungsgliedern gebildeten dritten Schiebespeicherkette (SIII) verbunden ist, und die so gewonnenen Differenzenstrukturwerte $"D^4"y$ der Reihe nach im Eingangs-Abtasttakt (T) in die dritte Schiebespeicherkette (SIII) einspeist, wobei noch weitere Schiebespeicherketten mit weiteren Multiplizier-und Summiergliedern sooft angeschlossen sind, bis die letzte Schiebespeicherkette, die nur ein einziges Verzögerungsglied enthält, erreicht ist und daß weiters zur Ermittlung des für die Berechnung des Ausgangs-Abtastwertes y(t) erforderlichen Lageparameters u ein am Beginn eines jeden Eingangs-Abtastintervalles gestarteter, bis zum nächstfolgenden Ausgangs-Abtastzeitpunkt laufender und danach zurückgestellter Zeitzähler (ZZ) dient, dessen jeweiliges Zählresultat als Lageparameter u herangezogen ist und daß schließlich eine Rechnerschaltung vorgesehen ist, die aus den einem Eingangs-Abtastintervall zugeordneten Stützwerten $y_o$, $y_1$, ferner aus den diesem Intervall zugeordneten Differenzenstrukturwerten "$D^2$"$y_o$..."$D^4$"$y_1$, u.s.w. und schließlich aus den vom Lageparameter u (bzw. v = 1-u) abgeleiteten Koeffizienten

$$\binom{v+1}{3} \ldots \binom{u+2}{5}$$

den Ausgangs-Abtastwert y errechnet.

2. Einrichtung nach Anspruch 1, **dadurch gekennzeichnet,** daß zur Bildung der in der Interpolationsformel für den Ausgangs-Abtastwert y(n) vom Lageparameter u bzw. v abhängigen Binomialkoeffizienten (z.B.

$$\binom{v+1}{3}, \quad \binom{v+2}{5}$$

gemäß der Rekursionsformel

$$\binom{u+r}{2r+1} = \binom{u+(r-1)}{(2r-1)}$$

($A_r u^2 - B_r$) mit dem laufenden Index r = 1,2... die nur von diesem Index r abhängige Koeffizienten $A_r$ = $1/(2r(2r+1))$ und $B_r$ = $r^2/(2r(2r+1))$ enthaltender Speicher (RU,RV) vorgesehen ist, aus dem diese Koeffizienten ($A_r$,$B_r$) für eine sukzessive, mit steigendem Index r durchführbare Berechnung der Binomialkoeffizienten abrufbar sind.

3. Einrichtung nach Anspruch 1 oder 2, **dadurch gekennzeichnet,** daß die Anzahl der in der ersten Schiebespeicherkette (SI) enthaltenen Einheitsverzögerungsglieder (T) statt N nur den Wert INT((N + 1)-/2) aufweist und daß auch die weiteren Schiebespeicherketten (SII,SIII) um soviele Einheitsverzögerungsgliederverkürzt sind, daß jede dieser Speicherketten je ein Einheitsverzögerungsglied weniger als die sie über die Multiplizierglieder (M) mit Daten versorgende Speicherkette aufweist.

**Claims**

1. Device for the conversion of a digital signal $y_n$ = y(n.T); (n = 0,1,2..) received at a pre-determined input sampling rate (f = 1/T), which signal represents an originally analogue signal by means of its sampling values at the sampling times (n.T), into other output sampling values $y_k$ = y(k.T'); (k = 0,1,2...) which have an output sampling rate (f' = 1/T') which is (in general) different from the input sampling rate (f), wherein these output sampling values are also a valid signal representation of the original analogue signal, with the use of an interpolation computer which, on the one hand, calculates back-up values derived from successive input sampling values and, on the other hand, calculates the output sampling values from time differences between input and output sampling times measured by means of a time counter, characterised in that there is provided a differential structure computer for obtaining an output sampling value y located temporally between two adjacent input sampling values $y_0$ = y(mT) and $y_1$ = y((m + 1)T) and in the form of the function value of a polynomial of the Nth order with

$$m = n-\text{INT}\left(\frac{N+1}{2}\right),$$

according to the formula (Everett Formula):

$$y(u) = vy_0 + \binom{v+1}{3} \text{"}D^2\text{"}(y_0) + \binom{v+2}{5} \text{"}D^4\text{"}(y_0) + \ldots$$
$$+ uy_1 + \binom{u+1}{3} \text{"}D^2\text{"}(y_1) + \binom{u+2}{5} \text{"}D^4\text{"}(y_1) + \ldots$$

wherein the positional parameters u and v = 1-u defined in a linear manner in the interval between the back-up values $y_0$ and $y_1$ as the range between 0 and 1, determine the interpolation value y(u) located between the limits $y_0 = y(u=0)$ and $y_1 = y(u=1)$, and wherein the expressions

$$\text{"}D^2\text{"}(y_0) = y_{-1} - 2y_0 + y_1$$

and

$$\text{"}D^4\text{"}(y_0) = \text{"}D^2\text{"}y_{-1} - 2\text{"}D^2\text{"}y_0 + \text{"}D^2\text{"}y_{+1}$$

etc.

signify special differential structures of the second and fourth, sixth etc. order of three respective successive values $y_{-1} = y((m-1)T)$; $y_0 = y(mT)$; $y_1 = y((m+1)T)$, and in that the differential structure computer comprises shift memory chains of different orders, wherein the input sampling values y(nT), y((n-1)T), y((n-2)T),... pass through the first shift memory chain (SI) in time with the input sampling rate (f), which shift memory chain (SI) comprises memories and a cascade of N standardised time-delay elements connected in series and each having a delay time with the duration of a sampling period T, and in that, to the first three memories of the first shift memory chain (SI), there is connected a respective multiplier element (M) for the multiplication of the contents of these three memories ($SI_1$...) by the factors +1, -2 or +1, and the outputs of these multiplier elements (M) are further connected to a common summing element (SGI), the output of which is connected to the first memory of the second shift memory chain (SII) comprising memories and a cascade of N-2 standardised time-delay elements (T), and in turn feeds the differential structure values "$D^2$"y thus obtained at the input sampling rate (T) to the second shift memory chain (SII), and in that, in a similar way, a respective further multiplier element (M) for the multiplication of the contents of these three memories by the factors +1, -2 or +1 are connected to the first three memories of the second shift memory chain (SII), and the outputs of these multiplier elements (M) are connected to a further summing element (SGII), the output of which is connected to the first memory of a third shift memory chain (SIII) formed from a cascade having N-4 standardised time-delay elements, and in turn feeds the differential structure values "$D^4$"y obtained in this way at the input sampling rate (T) to the third shift memory chain (SIII), wherein further shift memory chains having further multiplier and summing elements are connected until the last shift memory chain, which contains only a single time-delay element, is reached, and in that, furthermore, for determining the positional parameter u required for the calculation of the output sampling value y(t), there serves a time counter (ZZ) which is started at the beginning of each input sampling interval, runs until the next following output sampling time and is reset thereafter, the respective counting result of this time counter (ZZ) being used as the positional parameter u, and in that, lastly, there is provided a computer circuit which calculates the output sampling value y from the back-up values $y_0$, $y_1$ assigned to an input sampling interval, and also from the differential structure values "$D^2$"$y_0$ ... "$D^4$"$y_1$ etc. assigned to this interval, and lastly from the coefficients

$$\binom{v+1}{3} \ldots \binom{u+2}{5}$$

derived from the positional parameter u (or v = 1-u).

**2.** Device according to claim 1, characterised in that, for the formation of binomial coefficients (for example,

$$\binom{v+1}{3}, \binom{v+2}{5}$$

according to the recurrence formula

$$\binom{u+r}{2r+1} = \binom{u+(r-1)}{(2r-1)}$$

$(A_r u^2 - B_r)$ with the current index $r = 1,2...$, which binomial coefficients are dependent upon the positional parameter u or v in the interpolation formula for the output sampling value $y(n)$, there is provided a memory (RU, RV) which contains only coefficients $A_r = 1/(2r(2r+1))$ and $B_r = r2/(2r(2r+1))$ dependent upon this index r, from which memory (RU, RV) these coefficients ($A_r$, $B_r$) can be retrieved for a successive calculation of the binomial coefficients, which calculation can be performed with an ascending index r.

**3.** Device according to claim 1 or 2, characterised in that the number of standardised time-delay elements (T) contained in the first shift memory chain (SI) has, instead of N, only the value INT((N + 1)/2), and in that the further shift memory chains (SII, SIII) are shortened by a number of standardised time-delay elements such that each of these memory chains has one respective standardised time-delay element fewer than the memory chain supplying them with data by way of the multiplier elements (M).

**Revendications**

**1.** Dispositif pour la conversion d'un signal numérique $Y_n = Y(n.T)$ ; $(n = 0,1,2...)$ reçu sous une vitesse d'entrée pré-programmée $(f = I/T)$, qui représente un signal primitivement analogique par ses valeurs de lectures moment $(n.T)$, en d'autres valeurs de lecture de sortie $y_k = y(K.T')$ ; $(k = 0,1,2...)$, lesquelles présentent une vitesse de balayage de sortie $(f' = I/T')$ en général différente de la vitesse de balayage d'entrée $(f)$, tandis que lesdites valeurs de balayage de sortie constituent également une représentation valable du signal analogique primitif, avec utilisation d'un calculateur par interpolation qui calcule les valeurs de balayage de sortie, d'une part, à partir de valeurs fixes dérivées de valeurs de balayage d'entrée successives et, d'autre part, à partir de différences de temps mesurées au moyen d'un chronomètre entre des moments de balayage d'entrée et de sortie, caractérisé par un calculateur à structure différentielle pour le calcul d'une valeur de balayage de sortie y située entre deux valeurs de balayage d'entrée voisines $y_0 = y(mT)$ et $y_1 = y((m+1)T)$, sous la forme de la valeur de la fonction d'un polynôme de degré N où

$$m = n - INT \frac{(N+1)}{2}$$

selon la formule suivante (formule de Everett) :

$$y(u) = vy_0 + \binom{v+1}{3}"D^2"(y_0) + \binom{v+2}{5}"D^4"(y_0) + ...$$

$$+ uy_1 + \binom{u+1}{3}"D^2"(y_1) + \binom{u+2}{5}"D^4"(y_1) + ...$$

où les paramètres de situation u et $v = 1-u$ définis comme étant la zone linéaire entre 0 et 1 dans l'intervalle entre les valeurs fixes $y_0$ et $y_1$ déterminent la valeur d'interpolation $y(u)$ située entre les limites $y_0 = y(u=0)$ et $y_1 = y(u=1)$ et où les expressions

$"D^2"(y_0) = y_{-1} - 2y_0 + y_1$

9

et

$$"D^4"(y_o) = "D^2"y_{-1} - 2"D^2"y_o + "D^2"y_{+1}$$

etc.,

signifient des structures spécifiques de deuxième et quatrième, de sixième, etc. ordres de respective-ment trois valeurs successives $y_{-1} = y((m-1)T)$ ; $y_0 = y(mT)$ ; $y_1 = y((m+1)T)$, et en ce que le calculateur à structure différentielle est constitué de chaînes de mémoires à décalage d'ordres différents, dont la première chaîne (SI) constituée de mémoires et d'une cascade de M lignes à retard unitaires montées successivement présentant chacune un temps de retard égal à une période de balayage T, est parcourue par les valeurs de balayage d'entrée y(nT), y((n-1)T), y((n-2)T),... au rythme de la vitesse de balayage d'entrée (f), et en ce que pour chacune des trois premières mémoires de la première chaîne (SI) est connecté un organe multiplicateur (M) pour multiplier les contenus de ces trois mémoires (SI$_1$...) par les facteurs +1, -2 ou +1 et en ce que les sorties de ces organes multiplicateurs (M) sont connectées, par ailleurs, à un organe sommateur commun (SGI) dont la sortie est reliée à la première mémoire de la deuxième chaîne (SII) constituée de mémoires et d'une cascade de M-2 lignes à retard unitaires (T) et en ce que les valeurs de structure différentielles ainsi obtenues "D$^2$"y sont introduites dans l'ordre, au rythme du balayage d'entrée (T) dans ladite deuxième chaîne (SII) et en ce que, de manière analogue, à chacune des trois premières mémoires de la deuxième chaîne (SII) est raccordé un autre organe multiplicateur (M) pour la multiplication du contenu de ces trois mémoires par les facteurs +1, -2 ou +1 et en ce que les sorties de ces organes multiplicateurs (M) sont connectées à un autre organe sommateur (SGII) dont la sortie est reliée à la première mémoire d'une troisième chaîne (SIII) formée d'une cascade de lignes à retard unitaires N-4 et que les valeurs de structure différentielles ainsi acquises "D$^4$"y sont introduites dans l'ordre, à la vitesse de balayage d'entrée (T), dans ladite troisième chaîne (SIII), tandis que d'autres chaînes de mémoires à décalage sont connectées à d'autres organes multiplicateurs et sommateurs suffisamment souvent pour que la dernière chaîne, qui ne contient qu'une seule ligne à retard, soit atteinte et que, ensuite, pour l'obtention du paramètre de position u nécessaire pour le calcul de la valeur de balayage de sortie y(t), soit utilisé un chronomètre (ZZ) qui démarre au début de chaque intervalle de balayage d'entrée, qui tourne jusqu'au moment de balayage de sortie immédiatement consécutif et qui est ensuite remis à zéro, chronomètre dont le résultat est utilisé comme paramètre de position u, et enfin en ce qu'est prévu un circuit calculateur qui calcule, à partir des valeurs fixes associées à un intervalle de balayage d'entrée $y_0$, $y_1$, ensuite à partir des valeurs de structure différentielles associées à cet intervalle "D$^2$"$y_0$..."D$^4$"$y_1$, etc. et enfin à partir des coefficients

$$(\underline{v+1})...(\underline{u+2})$$
$$\quad 3 \qquad\quad 5$$

dérivés du paramètre u (en l'occurrence v = 1-u), la valeur de balayage de sortie.

2. Dispositif selon la revendication 1, caractérisé en ce que, pour former les coefficients binomiaux (par exemple

$$(\underline{\ddot{v}+1}) \quad (\underline{v+2})$$
$$\quad 3 \qquad\quad 5$$

qui, dans la formule d'interpolation pour la valeur de balayage de sortie y(n) dépendent du paramètre de situation u ou v selon la formule de récursion

$$(\underline{u+r}) \quad = \frac{(\underline{u+(r-1)})}{(2r-1)}(A_r u^2 - B_r),$$
$$(2r+1)$$

10

avec l'indice constant r = 1,2..., est prévue la mémoire (RU, RV) contenant des coefficients $A_r$ = 1/(2r-(2r+1)) et $B_r$ = $r^2$/(2r(2r+1)) qui ne dépendent que de cet indice r, mémoire dans laquelle ces coefficients ($A_r$, $B_r$) peuvent être sélectionnés pour effectuer un calcul successif à indice r croissant des coefficients binomiaux.

3. Dispositif selon la revendication 1 ou 2, caractérisé en ce que le nombre des lignes à retard unitaires (T) contenues dans la première chaîne (SI) de mémoires à décalage présente non la valeur M mais seulement la valeur INT((M+1)/2) et que les autres chaînes (SII, SIII) également sont raccourcies d'autant de lignes à retard unitaires pour que chacune de ces chaînes présente une ligne à retard de moins que la chaîne qui l'alimente en données par l'intermédiaire des organes multiplicateurs (M).

FIG 1

FIG 2

FIG 3

FIG 4

INT $\left(\frac{N+1}{2}\right)$ Verzögerungsglieder T

$\underline{SI}$

$y_n = y(m + INT [\frac{N+1}{2}])$,
$y_1 = y((m+1)T), y_0 = y(mT)$

$\underline{SII}$

$p = INT(\frac{N+1}{2})$

$("D^2"(y_{n-1}))$

$("D^4"(y_{n-2}))$

$\underline{SIII}$

zur Interpolation herangezogene Werte
$y_0, y_1, "D_{y0}^2", \ldots \ldots$

EP 0 387 507 B1

FIG 5